# EUROPEAN PATENT SPECIFICATION

(11) **EP 3 480 510 B1**
(45) Date of publication and mention of the grant of the patent: **25.03.2020**
(21) Application number: 18174862.5
(22) Date of filing: 29.05.2018
(51) Int. Cl.: F21K 9/23, F21Y 115/10

(54) **LED LIGHTING APPARATUS**
LED-BELEUCHTUNGSVORRICHTUNG
APPAREIL D'ÉCLAIRAGE À DEL

(30) Priority: 03.11.2017 CN 201711071228; 23.01.2018 CN 201820109996 U
(43) Date of publication of application: 08.05.2019
(73) Proprietor: Xiamen Eco Lighting Co., Ltd., Xiamen Fujian 363999 (CN)
(72) Inventor: Jiang, Hongkui, Xiamen, Fujian 361010 (CN); Gao, Yanzeng, Xiamen, Fujian 361010 (CN); Zheng, Qiuling, Xiamen, Fujian 361010 (CN); Chen, Yanbiao, Xiamen, Fujian 361010 (CN); Chen, Huiwu, Xiamen, Fujian 361010 (CN); Cao, Liangliang, Xiamen, Fujian 361010 (CN)
(74) Representative: Dilg, Haeusler, Schindelmann Patentanwaltsgesellschaft mbH

(56) References cited:
- EP-A1- 3 065 174
- CN-A- 105 698 129
- CN-U- 203 907 532
- GB-A- 2 547 085
- US-A1- 2013 322 081
- US-A1- 2015 069 442
- US-A1- 2016 043 292

## Description

### Field of the Invention

The present invention is related to a LED lighting apparatus and more particularly related to a LED lighting apparatus emitting a wide range of light in a three dimension space.

### Background

There are various lighting apparatuses widely used in daily life. For example, it is common to find more than one light bulbs in a house. With the new LED technology, due to great luminance efficacy and other advantages, LED lighting apparatuses are quickly replacing lots of traditional lighting devices. LED lighting apparatuses are for example described in US 2015/069442, EP 3065174 and GB 2547085.

Nevertheless, there are certain decoration needs on the appearance of LED lighting apparatuses. In addition, it is important to keep luminance efficacy, heat dissipation and other factors while considering appearance. Therefore, it is always a challenge to discover and invents new ways to implement LED lighting apparatuses.

On the other hand, since LED lighting apparatuses are so widely used in today's life, any advancement of LED lighting apparatuses may bring great benefit to human world.

### Summary of Invention

According to an embodiment of the present invention, as disclosed in claim 1, a LED lighting apparatus includes a driver, a substrate, a plurality of LED chips, a first fluorescent layer, and a second fluorescent layer. The driver converts an external power source to a driving current. For example, the driver converts a 110V-220V alternating power source to a direct current suitable for driving the LED chips to emit light.

The substrate is mounted with two electrodes electrically connected to the driver for getting the driving current. In some cases, there may be more than two electrodes on one substrate. For example, more than one sets of LED chips connected in series are placed on the substrate and receive electricity separately so as to separately turn on, turn off, or adjust current of different sets of LED chips.

The plurality of LED chips are mounted on a first side of the substrate.

The first fluorescent layer is disposed on the first side of the substrate covering the plurality of LED chips. A second fluorescent layer is disposed on a second side of the substrate. In one case, the substrate is a polygonal thin plate. In such case, the first side of the substrate and the second side of the substrate may be two opposite sides of the substrate. In another case, the substrate may be a cylinder, a tube, or a wire-shape bar. In such case, there may be more than two "second sides" fixed with "second fluorescent layers" of same or different fluorescent material.

A part of a first light is emitted from the plurality of LED chips passing through the first fluorescent layer to form a third light. The third light is emitted into and excites the second fluorescent layer to emit a second light. The total luminance level of the third light is not less than 20% of the second light. The thickness of the first fluorescent layer and second fluorescent layer are controlled to achieve such luminance level setting for the total luminance level of the third light and the second light. In addition, the overall distance between the third light escaped from the first fluorescent layer and the second light escapade from the second fluorescent layer is controlled to help achieve the luminance setting. Other methods, like providing an additional light source to emit light into the second fluorescent layer, or providing a reflector below the second fluorescent layer, may also be used to achieve the overall luminance setting.

In some cases, the first fluorescent layer and the second fluorescent layer may have the same material. In other cases, the first fluorescent layer comprises green phosphor material and red phosphor material for generating a green light and a red light, and the second fluorescent layer comprises blue phosphor material for generating a blue light.

In some embodiments, a third light is generated after the first light is passing through the first fluorescent layer. The third light and the second light have different optical spectrum characteristics. For example, the third light includes more green and red light and the second light includes more blue light. The third light and the second light together forms a white light.

In some embodiments, the substrate, the plurality of LED chips, the first fluorescent layer, and the second fluorescent layer together form an elongated light emitting strip. For example, the substrate is disposed with the plurality of LED chips covered by the first fluorescent layer. In addition, on the back side of the substrate, the substrate is disposed with the second fluorescent layer. Related electrodes may also disposed at two ends for such module. The LED chips may be connected by inner wires for connecting in series, or in series and in parallel.

In some embodiments, the substrate is arranged for the first light and the second light together covering more than 70% directions in a three dimension. In other words, such light module provides a wide range of light emitting directions in a three dimension space.

In some embodiments, the LED lighting apparatus is a LED bulb. In such case, the LED bulb may also include a cap with two electrodes connecting to an external socket like an Edison socket. The LED bulb may also include a bulb shell. The driver is disposed in a containing space of the cap. He, H₂ and/or O₂ is filled in the sealed space of the bulb shell for helping protect the LED chips and/or help heat dissipation.

More than one LED modules composed of the substrate, the LED chips, the first fluorescent layer and the second fluorescent layer may be disposed in a LED bulb shell. These LED modules may be arranged and positioned so that third light escaped from the first fluorescent layer has some portion enters the second fluorescent layer to form the second light.

In some cases, the substrate is a flexible material, and the substrate is twisted or bent to control the light emitting directions of the LED chips. In some cases, there is only one such LED module. The only LED module is bent or twisted so that at least some LED chips have their light emitting directions directing to the second fluorescent layer of the same LED module. In such case, the LED chips, even on the same substrate, emit light in different directions.

In some embodiments, the LED module has its substrate bent so that the plurality of LED chips emit the first light in multiple directions.

In some embodiments, the substrate has multiple straight parts connected with at least one bent portion, and the bent portion is part of the substrate. There may be one bent part or multiple bent parts disposed on the substrate. The substrate may have some flexible material in the bent part while rigid material in other parts so as the rigid parts keep straight shape and the bent parts keep bent shape.

In some embodiments, a pillar is provided to fix to the bent portion to support the substrate. For example, a metal bracket may be extended from a bottom of a LED light bulb to fix the bent portion for supporting the substrate. The metal bracket may be replaced with a transparent glass or plastic pillar. The pillar may help transmit heat of the substrate to other places of the LED lighting apparatus.

In some embodiments, the LED lighting apparatus includes a transparent pillar fixed to the substrate to position the plurality of LED chips to a predetermined positions.

In some embodiments, the substrate is twisted as a spiral form. For example, the substrate is twisted like a spiral spring shape. In such case, light emitting from the first fluorescent layer have great chance to enter the second fluorescent layer even in the same substrate.

In some embodiments, the second side of the substrate is disposed with a reflective layer for reflecting light. There may also be a concave surface or a convex surface on the second side of the substrate. With such component attached, formed or coated on the second side of the substrate, there is better luminance efficacy for generating the second light.

In some embodiments, the substrate is not transparent. In other words, light emitted from the LED chips are firstly passing through the first fluorescent layer before reaching the second fluorescent layer. In some other cases, the substrate is transparent, and light emitted from the LED chips may have some portion directly moving to the second fluorescent layer.

In some embodiments, there is a second source emitting a fourth light to the second fluorescent layer to increase overall light output of the second light.

In some embodiments, the second light emits on the first fluorescent layer to generate a fifth light.

In some embodiments, the second side of the substrate ismounted with a second set of LED chips.

In some embodiments, the first fluorescent layer comprises multiple segments for respectively converting the first light into lights of multiple different spectrums.

In some embodiments, the plurality of LED chips have solder bumps on chip pads of the plurality of LED chips for connecting to the substrate. The solder bumps are deposited on the chip pads on a top side of a wafer during a final wafer processing for manufacturing the plurality of LED chips.

In some embodiments, the LEDlightingapparatus further includes a plurality of metal wires partly disposed between the plurality of LED chips and the substrate for connecting the plurality of LED chips in series or in series and parallel.

In some embodiments, an outer surface of the second fluorescent layer is convex surface.

In some embodiments, an outer surface of the second fluorescent layer has micro concave structures for enhancing generation of the second light. Such micro concave structures may not need to be in perfect shapes, and may be seen and identified with a microscope.

### Brief Description of Drawings

Fig. 1 illustrates a cross-sectional view of a LED module of an embodiment.
Fig. 2 illustrates connection of LED chips in series.
Fig. 3 illustrates connection of LED chips in series and in parallel.
Fig. 4 illustrates a distribution manner of the LED chips.
Fig. 5 illustrates disposing the LED chips in multiple rows.
Fig. 6 illustrates a single color temperature embodiment.
Fig. 7 illustrates a multiple color temperature embodiment.
Fig. 8 illustrates a multiple color temperature embodiment.
Fig. 9 illustrates an exterior shape of the LED module.
Fig. 10 illustrates an exterior shape of the LED module.
Fig. 11 illustrates an exterior shape of the LED module.
Fig. 12 illustrates an exterior shape of the LED module.
Fig. 13 illustrates a light bulb example.
Fig. 14 illustrates a light bulb example.

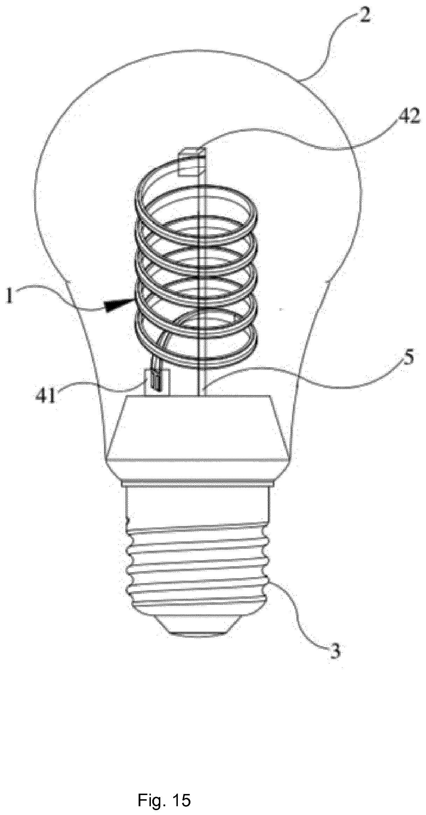

Fig. 15 illustrates another light bulb example.
Fig. 16 illustrates a cross-sectional view of a LED module.
Fig. 17 illustrates a different substrate shape.
Fig. 18 illustrates using pillars for fixing and supporting a bent LED module.

### Detailed Description

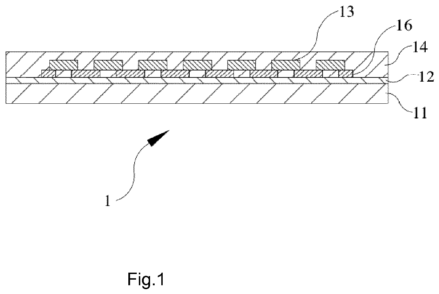

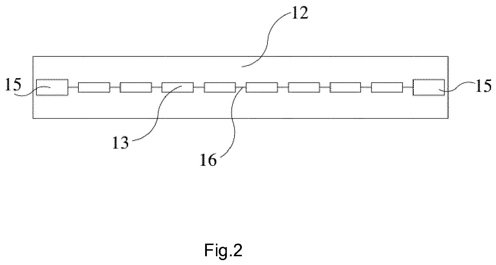

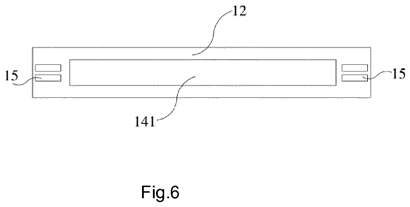

Please refer to Fig. 1, Fig. 2 and Fig. 6. Fig. 1 illustrates a cross-sectional view of a LED module of an embodiment. Fig. 2 illustrates connection of LED chips in series. Fig. 6 illustrates a single color temperature embodiment.

A flexible LED module 1 includes a flexible metal substrate 11, an insulation layer 12, LED chips 13 for generating light, a fluorescent glue layer 14 for packaging the LED chips and electrodes 15 for connecting to an external power source.

The insulation layer 12 is disposed above the flexible metal substrate 11. There are more than one LED chips 13. The LED chips 13 disposed above the insulation layer 12. The fluorescent glue layer 14 is formed above the insulation layer 12 and covers the LED chips 13. The electrodes 15 are disposed at distal ends of the flexible metal substrate 11 and electrically connected to the LED chips 13.

The electrodes 15 may be made as pluggable terminals to be inserted into corresponding sockets for getting an external power source.

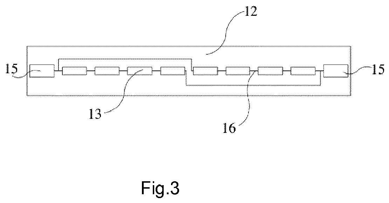

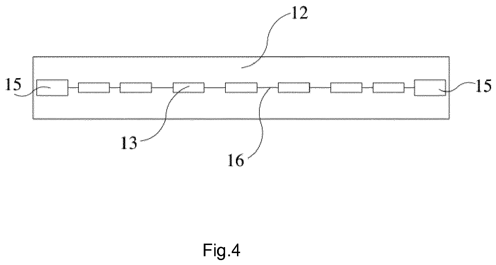

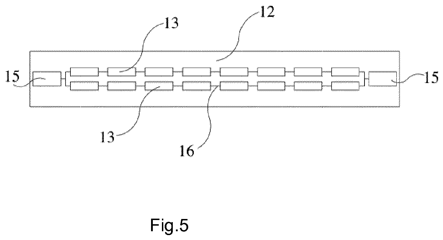

In Fig. 2, there are multiple LED chips 13 connected in series. Adjacent LED chips are connected by a metal wire 16. Fig. 3, Fig. 4 an Fig. 5 illustrate other ways for connecting the LED chips 13.

In Fig. 6, the fluorescent glue layer 14 has a first color temperature area 141, including associated phosphor powder for generating a first color temperature when light emitted from the LED chips 13 excites the phosphor powder to generate a output light.

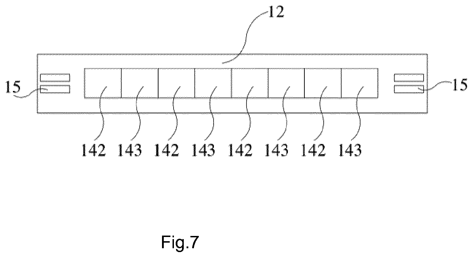

In Fig. 7, there are two types of color temperature areas 142, 143, providing different light color temperature output.

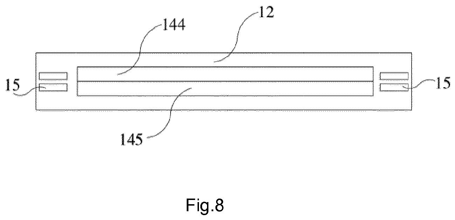

In Fig. 8, two color temperature areas 144, 145 are arranged in another manner, compared with Fig. 7.

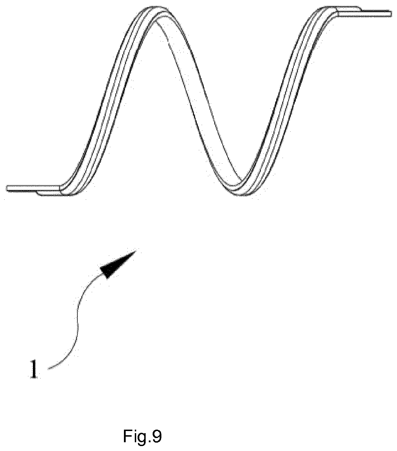

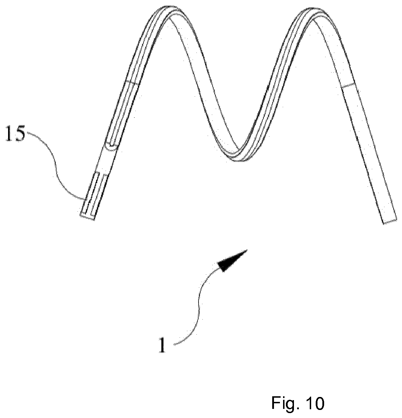

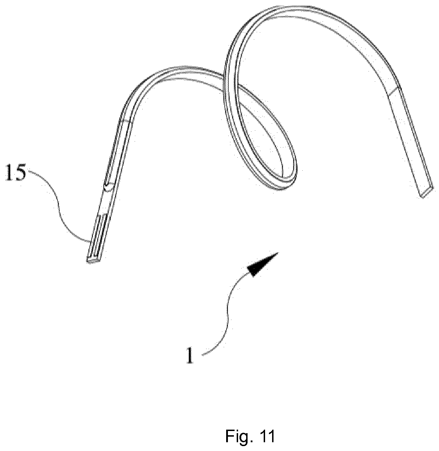

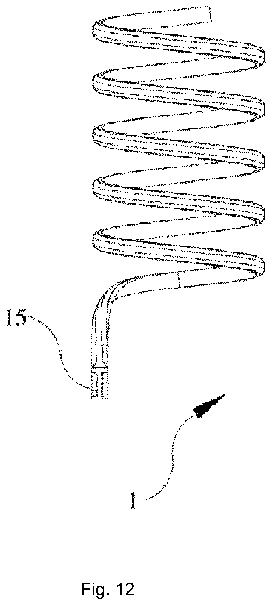

Please refer to Fig. 9, Fig. 10, Fig. 11, and Fig. 12, illustrating different ways to bent for setting the LED chips to emit different light directions.

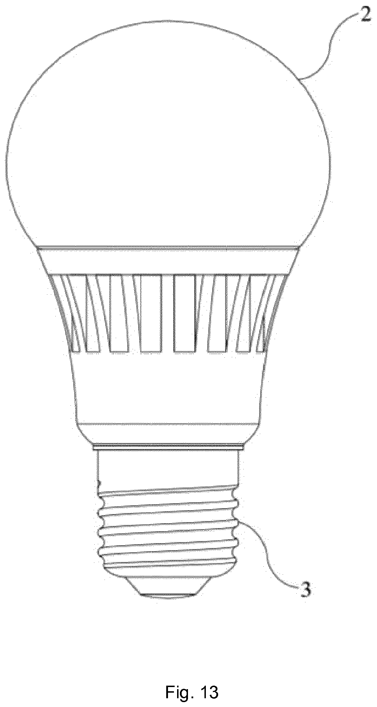

Fig. 13 illustrates a bulb example, having a bulb shell 2 and cap 3.

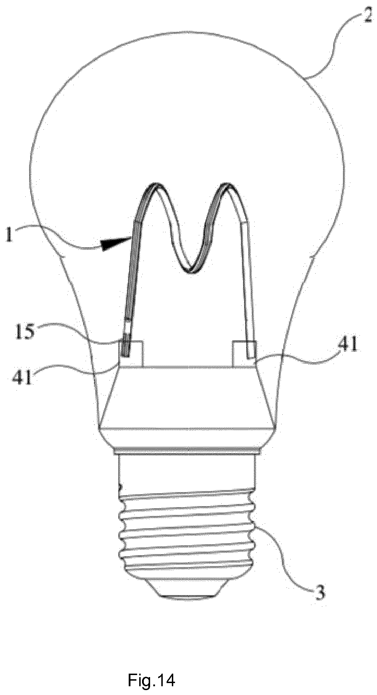

Fig. 14 illustrates a bulb example, in which the LED module 1 are plugged to two terminals 41, 42 for both supporting and getting electricity.

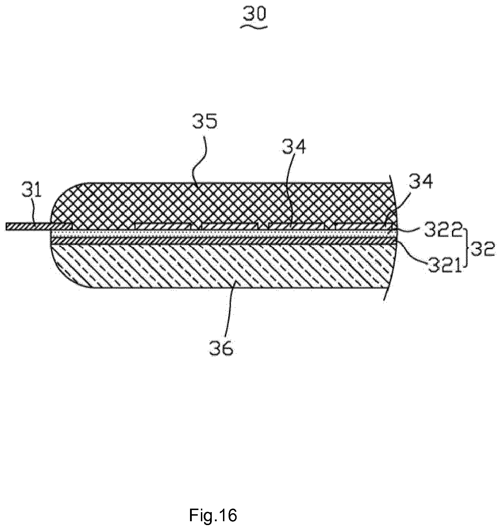

In Fig. 16, a LED module 30 includes a substrate 32, multiple LED chips 34 and a fluorescent layer 35. The substrate 32 is made of flexible material. The LED chips 34 are fixed on the substrate 32. The substrate 32 has a wiring layer 322 and a metal layer 321. The LED chips 34 are flip chipshaving solder bumps on their chip pads for connecting to the substrate 32. The solder bumps are deposited on the chip pads on a top side of a wafer during a final wafer processing for manufacturing the LED chips 34.

Another fluorescent layer 36 is formed on the back side of the substrate 32.

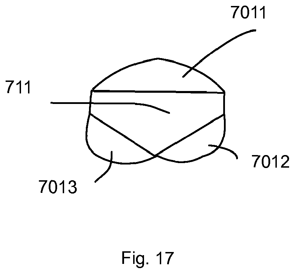

Fig. 17 is cross-sectional view of a substrate and related fluorescent layers. The substrate 711 has a flat first side covered with a first fluorescent layer 7011. The substrate 711 also has two back sides respectively covered with a second fluorescent layer 7012 and 7013. Reflection layer may be fixed on the two back sides of the substrate 711. The surface of the first fluorescent layer 7011, the second fluorescent layer 7012, and the third fluorescent layer 7013 may have convex surface or concave surface.

There may be a lot of micro concave structures that can be seen via a microscope for enhancing surface for generating higher light efficiency.

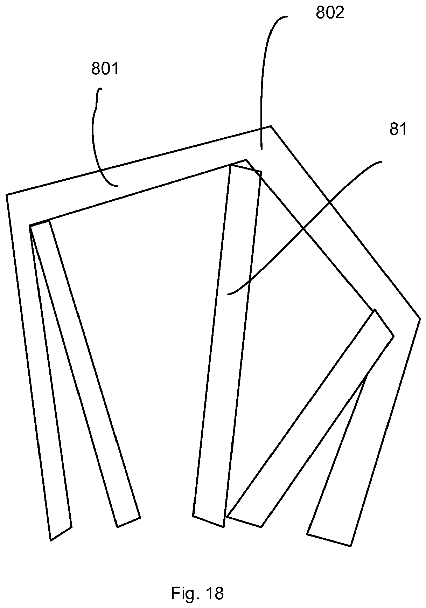

Fig. 18 illustrates a bent LED module having some straight parts 801 and some bent parts 802. The bent parts are fixed to and supported by pillars 81 to control light emitting directions of the LED chips on the bent LED module.

According to an embodiment of the present invention, a LEDlighting apparatus includes a driver, a substrate, a plurality of LED chips, a first fluorescent layer, and a second fluorescent layer. The driver converts an external power source to a driving current. For example, the driver converts a 110V-220V alternating power source to a direct current suitable for driving the LED chips to emit light.

The substrate is mounted with two electrodes electrically connected to the driver for getting the driving current. In some cases, there may be more than two electrodes on one substrate. For example, more than one sets of LED chips connected in series are placed on the substrate and receive electricity separately so as to separately turn on, turn off, or adjust current of different sets of LED chips.

The plurality of LED chips are mounted on a first side of the substrate.

The first fluorescent layer is disposed on the first side of the substrate covering the plurality of LED chips. A second fluorescent layer is disposed on a second side of the substrate. In one case, the substrate is a polygonal thin plate. In such case, the first side of the substrate and the second side of the substrate may be two opposite sides of the substrate. In another case, the substrate may be a cylinder, a tube, or a wire-shape bar. In such case, there may be more than two "second sides" fixed with "second fluorescent layers" of same or different fluorescent material.

A part of a first light is emitted from the plurality of LED chips passing through the first fluorescent layer to form a third light. The third light is emitted into and excites the second fluorescent layer to emit a second light. The total luminance level of the third light is not less than 20% of the second light. For example, the thickness of the first fluorescent layer and second fluorescent layer are controlled to achieve such luminance level setting for the total luminance level of the third light and the second light. In addition, the overall distance between the third light escaped from the first fluorescent layer and the second light escapade from the second fluorescent layer is controlled to help achieve the luminance setting. Other methods, like providing an additional light source to emit light into the second fluorescent layer, or providing a reflector below the second fluorescent layer, may also be used to achieve the overall luminance setting.

In some cases, the first fluorescent layer and the second fluorescent layer may have the same material. In other cases, the first fluorescent layer comprises green phosphor material and red phosphor material for generating a green light and a red light, and the second fluorescent layer comprises blue phosphor material for generating a blue light.

In some embodiments, a third light is generated after the first light is passing through the first fluorescent layer. The third light and the second light have different optical spectrum characteristics. For example, the third light includes more green and red light and the second light includes more blue light. The third light and the second light together forms a white light.

In some embodiments, the substrate, the plurality of LED chips, the first fluorescent layer, and the second fluorescent layer together form an elongated light emitting strip. For example, the substrate is disposed with the plurality of LED chips covered by the first fluorescent layer. In addition, on the back side of the substrate, the substrate is disposed with the second fluorescent layer. Related electrodes may also disposed at two ends for such module. The LED chips may be connected by inner wires for connecting in series, or in series and in parallel.

In some embodiments, the substrate is arranged for the first light and the second light together covering more than 70% directions in a three dimension. In other words, such light module provides a wide range of light emitting directions in a three dimension space.

In some embodiments, the LED lighting apparatus is a LED bulb. In such case, the LED bulb may also include a cap with two electrodes connecting to an external socket like an Edison socket. The LED bulb may also include a bulb shell. The driver is disposed in a containing space of the cap. He, H₂ and/or O₂ is filled in the sealed space of the bulb shell for helping protect the LED chips and/or help heat dissipation.

More than one LED modules composed of the substrate, the LED chips, the first fluorescent layer and the second fluorescent layer may be disposed in a LED bulb shell. These LED modules may be arranged and positioned so that third light escaped from the first fluorescent layer has some portion enters the second fluorescent layer to form the second light.

In some cases, the substrate is a flexible material, and the substrate is twisted or bent to control the light emitting directions of the LED chips. In some cases, there is only one such LED module. The only LED module is bent or twisted so that at least some LED chips have their light emitting directions directing to the second fluorescent layer of the same LED module. In such case, the LED chips, even on the same substrate, emit light in different directions.

In some embodiments, the LED module has its substrate bent so that the plurality of LED chips emit the first light in multiple directions.

In some embodiments, the substrate has multiple straight parts connected with at least one bent portion, and the bent portion is part of the substrate. There may be one bent part or multiple bent parts disposed on the substrate. The substrate may have some flexible material in the bent part while rigid material in other parts so as the rigid parts keep straight shape and the bent parts keep bent shape.

In some embodiments, a pillar is provided to fix to the bent portion to support the substrate. For example, a metal bracket may be extended from a bottom of a LED light bulb to fix the bent portion for supporting the substrate. The metal bracket may be replaced with a transparent glass or plastic pillar. The pillar may help transmit heat of the substrate to other places of the LED lighting apparatus.

In some embodiments, the LED lighting apparatus includes a transparent pillar fixed to the substrate to position the plurality of LED chips to a predetermined positions.

In some embodiments, the substrate is twisted as a spiral form. For example, the substrate is twisted like a spiral spring shape. In such case, light emitting from the first fluorescent layer have great chance to enter the second fluorescent layer even in the same substrate.

In some embodiments, the second side of the substrate is disposed with a reflective layer for reflecting light. There may also be a concave surface or a convex surface on the second side of the substrate. With such component attached, formed or coated on the second side of the substrate, there is better luminance efficacy for generating the second light.

In some embodiments, the substrate is not transparent. In other words, light emitted from the LED chips are firstly passing through the first fluorescent layer before reaching the second fluorescent layer. In some other cases, the substrate is transparent, and light emitted from the LED chips may have some portion directly moving to the second fluorescent layer.

In some embodiments, there is a second source emitting a fourth light to the second fluorescent layer to increase overall light output of the second light.

In some embodiments, the second light emits on the first fluorescent layer to generate a fifth light.

In some embodiments, the second side of the substrate ismounted with a second set of LED chips.

In some embodiments, the first fluorescent layer comprises multiple segments for respectively converting the first light into lights of multiple different spectrums.

In some embodiments, the plurality of LED chips have solder bumps on chip pads of the plurality of LED chips for connecting to the substrate. The solder bumps are deposited on the chip pads on a top side of a wafer during a final wafer processing for manufacturing the plurality of LED chips.

In some embodiments, the LEDlightingapparatus further includes a plurality of metal wires partly disposed between the plurality of LED chips and the substrate for connecting the plurality of LED chips in series or in series and parallel.

In some embodiments, an outer surface of the second fluorescent layer is convex surface.

In some embodiments, an outer surface of the second fluorescent layer has micro concave structures for enhancing generation of the second light. Such micro concave structures may not need to be in perfect shapes, and may be seen and identified with a microscope.

## Claims

1. A LED lighting apparatus (1), comprising:
a driver for converting an external power source to a driving current;
a substrate (11, 32) mounted with two electrodes electrically connected to the driver for getting the driving current;
a plurality of LED chips (13, 34) mounted on a first side of the substrate;
a first fluorescent layer (14, 35) disposed on the first side of the substrate (11, 32) covering the plurality of LED chips (13, 34); and
a second fluorescent layer (36, 7012, 7013) disposed on a second side of the substrate (11, 32), a part of a first light emitted from the plurality of LED chips (13, 34) passing through the first fluorescent layer (14, 35) and then exciting the second fluorescent layer (36, 7012, 7013) to emit a second light, a third light being generated after the first light is passing through the first fluorescent layer (14, 35), the third light and the second light having different optical spectrum characteristics,
**characterized in that**
the thickness of the first fluorescent layer (14, 35) and second fluorescent layer (36, 7012, 7013) are controlled so that the total luminance level of the third light is not less than 20% of the second light.

2. The LED lighting apparatus (1) of claim 1, wherein the substrate (11, 32), the plurality of LED chips (13, 34), the first fluorescent layer (14, 35), and the second fluorescent layer (36, 7012, 7013) together form an elongated light emitting strip.

3. The LED lighting apparatus (1) of claim 1, wherein the substrate (11, 32) is arranged for the first light and the second light together covering more than 70% directions in a three dimension.

4. The LED lighting apparatus (1) of claim 1, wherein the substrate (11, 32) is flexible; the substrate (11, 32)is bent so that the plurality of LED chips (13, 34) emit the first light in multiple directions.

5. The LED lighting apparatus (1) of claim 1, wherein the substrate (11, 32) has multiple straight parts connected with at least one bent portion, the bent portion is part of the substrate (11, 32).

6. The LED lighting apparatus (1) of claim 1, further comprising a transparent pillar (81) fixed to the substrate to position the plurality of LED chips to a predetermined positions.

7. The LED lighting apparatus (1) of claim 1, wherein the substrate (11, 32) is twisted as a spiral form.

8. The LED lighting apparatus (1) of claim 1, wherein the second side of the substrate (36, 7012, 7013) is disposed with a reflective layer for reflecting light.

9. The LED lighting apparatus (1) of claim 1, further comprising a second source emitting a fourth light to the second fluorescent layer.

10. The LED lighting apparatus (1) of claim 1, wherein the second light emits on the first fluorescent layer (14, 35) to generate a fifth light.

11. The LED lighting apparatus of claim 1, wherein the first fluorescent layer comprises multiple segments for respectively converting the first light into lights of multiple different spectrums.

12. The LED lighting apparatus (1) of claim 1, wherein the plurality of LED chips (13, 34) have solder bumps on chip pads of the plurality of LED chips (13, 34) for connecting to the substrate (11, 32), the solder bumps are deposited on the chip pads on a top side of a wafer during a final wafer processing for manufacturing the plurality of LED chips (13, 34).

13. The LED lighting apparatus (1) of claim 1, further comprising a plurality of metal wires partly disposed between the plurality of LED chips (13, 34) and the substrate (11, 32)for connecting the plurality of LED chips (13, 34) in series or in series and parallel.

14. The LED lighting apparatus (1) of claim 1, wherein an outer surface of the second fluorescent layer (7012, 7013) has micro concave structures for enhancing generation of the second light.

## Patentansprüche

1. Eine LED Beleuchtungsvorrichtung (1) aufweisend:
einen Treiber zum Konvertieren einer externen Leistungsquelle in einen Antriebsstrom;
ein Substrat (11, 32), welches mit zwei Elektroden montiert ist, welche elektrisch mit dem Treiber verbunden sind, um den Antriebsstrom zu beziehen;
eine Mehrzahl von LED Chips (13, 34), welche auf einer ersten Seite des Substrats montiert sind;
eine erste fluoreszierende Schicht (14, 35), welche auf der ersten Seite des Substrats (11, 32) angeordnet ist, welche die Mehrzahl von LED Chips (13, 34) bedeckt; und
eine zweite fluoreszierende Schicht (36, 7012, 7013), welche auf einer zweiten Seite des Substrats (11, 32) angeordnet ist, wobei ein Teil eines ersten Lichts, welches von der Mehrzahl von LED Chips (13, 34) emittiert wird, die erste fluoreszierende Schicht (14, 35) passiert und danach die zweite fluoreszierende Schicht (36, 7012, 7013) anregt, ein zweites Licht zu emittieren,
wobei ein drittes Licht erzeugt wird, nachdem das erste Licht die erste fluoreszierende Schicht (14, 35) passiert, wobei das dritte Licht und das zweite Licht verschiedene optische Spektraleigenschaften haben,
**dadurch gekennzeichnet, dass**
die Dicke der ersten fluoreszierenden Schicht (14, 35) und der zweiten fluoreszierenden Schicht (36, 7012, 7013) derartig eingestellt sind, dass der gesamte Luminanzpegel des dritten Lichts nicht niedriger als 20 % des zweiten Lichts ist.

2. Die LED Beleuchtungsvorrichtung (1) gemäß Anspruch 1, wobei das Substrat (11, 32), die Mehrzahl von LED Chips (13, 34), die erste fluoreszierende Schicht (14, 35) und die zweite fluoreszierende Schicht (36, 7012, 7013) zusammen einen länglichen, Licht emittierenden Streifen bilden.

3. Die LED Beleuchtungsvorrichtung (1) gemäß Anspruch 1, wobei das Substrat (11, 32) derartig eingerichtet ist, dass das erste Licht und das zweite Licht gemeinsam mehr als 70 % der Richtungen in drei Dimensionen abdecken.

4. Die LED Beleuchtungsvorrichtung (1) gemäß Anspruch 1, wobei das Substrat (11, 32) flexibel ist; wobei das Substrat (11, 32) derartig gebogen ist, dass die Mehrzahl von LED Chips (13, 34) das erste Licht in mehrere Richtungen emittieren.

5. Die LED Beleuchtungsvorrichtung (1) gemäß Anspruch 1, wobei das Substrat (11, 32) mehrere gerade Teile hat, welche mit zumindest einem gebogenen Abschnitt verbunden sind, wobei der gebogene Abschnitt ein Teil des Substrats (11, 32) ist.

6. Die LED Beleuchtungsvorrichtung (1) gemäß Anspruch 1, ferner aufweisend eine transparente Säule (81), welche an dem Substrat befestigt ist, um die Mehrzahl von LED Chips an vorbestimmten Positionen zu positionieren.

7. Die LED Beleuchtungsvorrichtung (1) gemäß Anspruch 1, wobei das Substrat (11, 32) zu einer Spiralform verdreht ist.

8. Die LED Beleuchtungsvorrichtung (1) gemäß Anspruch 1, wobei die zweite Seite des Substrats (36, 7012, 7013) mit einer reflektierenden Schicht zum Reflektieren von Licht vorgesehen ist.

9. Die LED Beleuchtungsvorrichtung (1) gemäß Anspruch 1, ferner aufweisend eine zweite Quelle, welche ein viertes Licht zu der zweiten fluoreszierenden Schicht emittiert.

10. Die LED Beleuchtungsvorrichtung (1) gemäß Anspruch 1, wobei das zweite Licht auf die erste fluoreszierende Schicht (14, 35) emittiert, um ein fünftes Licht zu erzeugen.

11. Die LED Beleuchtungsvorrichtung gemäß Anspruch 1, wobei die erste fluoreszierende Schicht mehrere Segmente aufweist, um jeweils das erste Licht in Lichter mit mehreren verschiedenen Spektren zu konvertieren.

12. Die LED Beleuchtungsvorrichtung (1) gemäß Anspruch 1, wobei die Mehrzahl von LED Chips (13, 34) Lötbumps auf Chip Pads der Mehrzahl von LED Chips (13, 34) haben, zum Verbinden mit dem Substrat (11, 32), wobei die Lötbumps auf den Chip Pads während einer finalen Wafer Verarbeitung zum Herstellen der Mehrzahl von LED Chips (13, 34) auf einer Oberseite eines Wafers angeordnet werden.

13. Die LED Beleuchtungsvorrichtung (1) gemäß Anspruch 1, ferner aufweisend eine Mehrzahl von Metalldrähten, welche teilweise zwischen der Mehrzahl von LED Chips (13, 34) und dem Substrat (11, 32) angeordnet sind, zum Verbinden der Mehrzahl von LED Chips (13, 34) in Serie oder in Serie und parallel.

14. Die LED Beleuchtungsvorrichtung (1) gemäß Anspruch 1, wobei eine äußere Oberfläche der zweiten fluoreszierenden Schicht (7012, 7013) mikrokonkave Strukturen zum Verstärken des Erzeugens des zweiten Lichts hat.

## Revendications

1. Appareil d'éclairage à LED (1), comprenant :
un excitateur pour convertir une source d'alimentation électrique externe en un courant d'excitation ;
un substrat (11, 32) monté avec deux électrodes électriquement connectées à l'excitateur pour obtenir le courant d'excitation ;
une pluralité de puces à LED (13, 34) montées sur une première face du substrat ;
une première couche fluorescente (14, 35) disposée sur la première face du substrat (11, 32) couvrant la pluralité de puces à LED (13, 34) ; et
une seconde couche fluorescente (36, 7012, 7013) disposée sur une seconde face du substrat (11, 32), une partie d'une première lumière émise de la pluralité de puces à LED (13, 34) passant à travers la première couche fluorescente (14, 35) et puis excitant la seconde couche fluorescente (36, 7012, 7013) pour émettre une deuxième lumière, une troisième lumière étant générée après que la première lumière passe à travers la première couche fluorescente (14, 35), la troisième lumière et la deuxième lumière ayant différentes caractéristiques de spectre optique,
**caractérisé en ce que**
les épaisseurs de la première couche fluorescente (14, 35) et de la seconde couche fluorescente (36, 7012, 7013) sont régulées pour que le niveau de luminance total de la troisième lumière ne soit pas inférieur à 20 % de la deuxième lumière.

2. Appareil d'éclairage à LED (1) selon la revendication 1, dans lequel le substrat (11, 32), la pluralité de puces à LED (13, 34), la première couche fluorescente (14, 35), et la seconde couche fluorescente (36, 7012, 7013) forment ensemble une bande luminescente allongée.

3. Appareil d'éclairage à LED (1) selon la revendication 1, dans lequel le substrat (11, 32) est agencé pour la première lumière et la deuxième lumière couvrant ensemble plus de 70 % de directions en trois dimensions.

4. Appareil d'éclairage à LED (1) selon la revendication 1, dans lequel le substrat (11, 32) est flexible ; le substrat (11, 32) est plié pour que la pluralité de puces à LED (13, 34) émettent la première lumière dans de multiples directions.

5. Appareil d'éclairage à LED (1) selon la revendication 1, dans lequel le substrat (11, 32) a de multiples parties droites connectées à au moins une portion pliée, la portion pliée fait partie du substrat (11, 32).

6. Appareil d'éclairage à LED (1) selon la revendication 1, comprenant en outre un pilier transparent (81) fixé au substrat pour positionner la pluralité de puces à LED dans des positions prédéterminées.

7. Appareil d'éclairage à LED (1) selon la revendication 1, dans lequel le substrat (11, 32) est tordu en forme de spirale.

8. Appareil d'éclairage à LED (1) selon la revendication 1, dans lequel la seconde face du substrat (36, 7012, 7013) est disposée avec une couche réfléchissante pour réfléchir de la lumière.

9. Appareil d'éclairage à LED (1) selon la revendication 1, comprenant en outre une seconde source émettant une quatrième lumière vers la seconde couche fluorescente.

10. Appareil d'éclairage à LED (1) selon la revendication 1, dans lequel la deuxième lumière est émise sur la première couche fluorescente (14, 35) pour générer une cinquième lumière.

11. Appareil d'éclairage à LED selon la revendication 1, dans lequel la première couche fluorescente comprend de multiples segments pour respectivement convertir la première lumière en lumières de multiples spectres différents.

12. Appareil d'éclairage à LED (1) selon la revendication 1, dans lequel la pluralité de puces à LED (13, 34) ont des bosses de brasure tendre sur des plages de puce de la pluralité de puces à LED (13, 34) pour la connexion au substrat (11, 32), les bosses de brasure tendre sont déposées sur les plages de puce sur une face supérieure d'une tranche durant un traitement de tranche final pour fabriquer la pluralité de puces à LED (13, 34).

13. Appareil d'éclairage à LED (1) selon la revendication 1, comprenant en outre une pluralité de fils métalliques partiellement disposés entre la pluralité de puces à LED (13, 34) et le substrat (11, 32) pour connecter la pluralité de puces à LED (13, 34) en série ou en série et parallèle.

14. Appareil d'éclairage à LED (1) selon la revendication 1, dans lequel une surface extérieure de la seconde couche fluorescente (7012, 7013) a des structures micro-concaves pour améliorer la génération de la deuxième lumière.
